Europäisches Patentamt

European Patent Office (11) Publication number: **0 401 795**

Office européen des brevets **A2**

(12) **EUROPEAN PATENT APPLICATION**

(21) Application number: 90110720.1

(22) Date of filing: 06.06.90

(51) Int. Cl.⁵: **G03F 1/14**

(30) Priority: 08.06.89 JP 146101/89
06.12.89 JP 315145/89

(43) Date of publication of application:
**12.12.90 Bulletin 90/50**

(84) Designated Contracting States:
**DE FR GB**

(71) Applicant: **Oki Electric Industry Company, Limited**
**7-12, Toranomon 1-chome Minato-ku**
**Tokyo 105(JP)**

(72) Inventor: **Jinbo, Hideyuki**
**Oki Electric Ind. Co., Ltd., 7-12 Toranomon 1-cho**

**Minato-ku, Tokyo(JP)**
Inventor: **Yamashita, Yoshio**
**Oki Electric Ind. Co., Ltd., 7-12 Toranomon 1-cho**
**Minato-ku, Tokyo(JP)**
Inventor: **Tomo, Yoichi**
**514-3 Kamitsuruma**
**Sagamihara-shi, Kanagawa-ken(JP)**
Inventor: **Kawazu, Yoshiyuki**
**Oki Electric Ind. Co., Ltd., 7-12 Toranomon 1-cho**
**Minato-ku, Tokyo(JP)**

(74) Representative: **Betten & Resch**
**Reichenbachstrasse 19**
**D-8000 München 5(DE)**

(54) **Phase-shifting photomask for negative resist and process for forming isolated, negative resist pattern using the phaseshifting photomask.**

(57) A photomask for a negative resist used for forming a resist image in the form of an isolated pattern. The photomask (40; 60; 70; 80; 90; 100; 120; 140) comprises a substrate (42; 82; 92; 102; 122; 142) transparent to an exposure light and a mask pattern (44; 62; 84 and 86; 94 and 96; 110; 132; 154) on the substrate. The mask pattern is formed of a phase-shifting layer (44; 62) alone or of a phase-shifting layer(s) (86; 96; 116; 130; 150) and a light-screening layer(s) (84; 94; 112; 124; 152). The phase-shifting layer is capable of shifting the phase of the light transmitted therethrough relatively to the phase of the light transmitted through the area of the photomask other than the area of the phase-shifting layer. A phase-shifting layer may be provided in such a way to substantially surround a light-screening layer having a width permitting of no resolution by itself. A phase-shifting layer may be provided in such a way to fill up an auxiliary aperture (114; 128; 148) provided in a light-screening layer. The portion of the phase-shifting layer filled in the aperture having a width permitting of no resolution by itself. With the use of the photomask, such a fine space or hole resist pattern as to exceed the resolution limit can be formed with excellent resolution and focus margin. A process for forming an isolated resist pattern using the photomask is also disclosed.

*FIG. 3* (a)

## Phase shifting Photomask for Negative Resist and Process for Forming Isolated, Negative Resist Pattern Using The Phase-Shifting Photomask

The present invention relates to a photomask for a negative resist which is used in photolithography through optical projection exposure, and particularly to a photomask which is used to form a resist image in the form of an isolated pattern. The present invention also relates to a process for forming resist pattern using the photomask of the kind as described above.

In the field of photolithography through optical projection exposure, intensive investigations have been made with a view to establishing a technology capable of fine resist pattern formation in step with increasing scales of integration in semiconductor devices. For example, a technique called the phase-shift process as disclosed in Literature I: [IEEE Transaction on Electron Devices, ED-29 (12), (1982.12), p. 1828] is a fruit of such investigation.

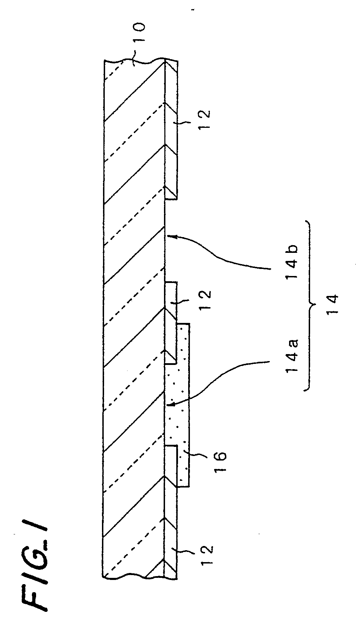

THe phase shift process disclosed in this literature is aimed at improving resolution in photolithography through optical projection exposure by shifting the phase of a light transmitted through areas of a photomask with a phase-shifting layer provided on the corresponding areas of the substrate of the photomask. Fig. 1 shows a conventional phase-shifting mask used in this process. This phase-shifting mask consists of a substrate 10 covered with an opaque layer 12 with aperture 14 (14a and 14b) periodically etched away therefrom and with a transparent phase-shifting layer 16 covering the aperture 14a. According to the above-mentioned literature, the phase shift process is said to be effective in formation of periodical pattern like a lines and spaces pattern (L & S).

Attempts to apply the phase-shift process to formation of a pattern isolated from the surroundings (hereinafter referred to as an "isolated pattern"), such as a space pattern or a hole pattern, are disclosed, for example, in Literature II: [49th Oyo-Butsuri Gakkai Gakujutsu Koenkai Yokoshu II, p. 497, Lecture No. 4a-K-7] and Literature III: [SPIE, Vol. 1088, Optical/Laser Microlithography, 11 (1989) pp. 25 - 33]. Here, the term "isolated pattern" refers to the projected light pattern of a noted mask pattern so apart from the projected light patterns of the other mask pattern(s) as not to cause interference therebetween when a plurality of mask patterns comprised of the noted mask pattern and the other mask pattern(s) are projected on a resist layer.

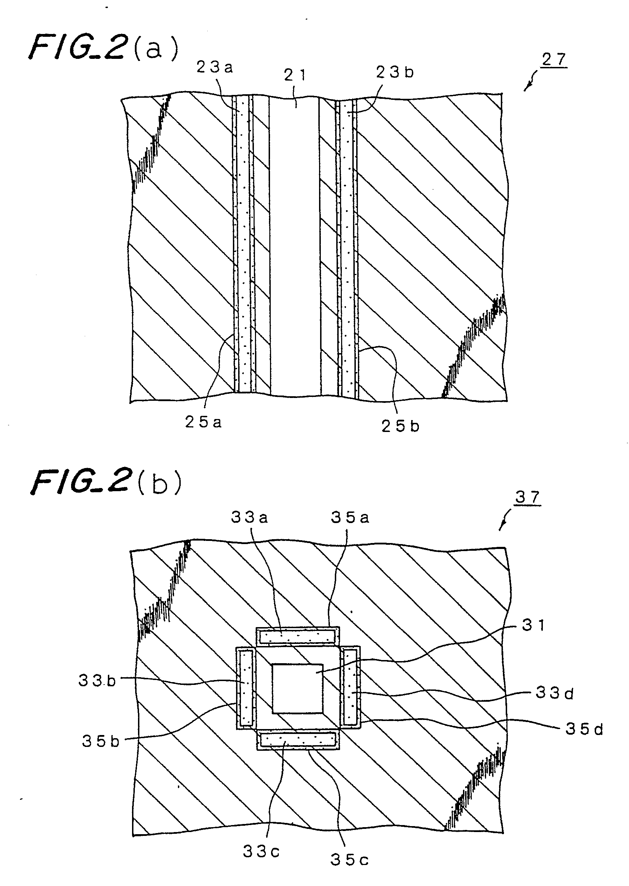

These pieces of literature disclose attempts to form an isolated pattern using a positive resist. Figs. 2(a) and (b) are schematic plan views of parts of respective photomasks for use in such isolated pattern formation.

According to the techniques disclosed in these pieces of literature, when a space pattern is to be formed, use is made of a photomask 27 as shown in Fig. 2(a)and provided with an aperture 21 corresponding to a space, with auxiliary apertures (also called "light transmission portions")23a and 23b with a width permitting of no resolution of a resist by themselves which are provided on both sides of the aperture 21 for the space with some distance from the aperture 21, and with phase-shifting layers 25a and 25b capable of shifting the phase of an exposure light by 180° which are provided on the respective auxiliary apertures 23a and 23b. The layers 25a and 25b lshown in the drawing are marked with dots. On the other hand, when a hole pattern is to be formed, use is made of a photomask 37 as shown in Fig. 2(b) and provided with an aperture 31 corresponding to a hole, with light transmission portion 33a, 33b, 33c and 33d with an area permitting of no resolution of a resist by themselves which are respectively provided near the four sides of the aperture 31 for the hole, and with phase-shifting layers 35a, 35b, 35c and 35d capable of shifting the phase of an exposure light by 180° which are provided on the respective light transmission portions. The layers 35a, 35b, 35c and 35d shown in the drawing are marked with dots.

With the use of either the photomask 27 or the photomask 37, the light intensity profile around a pattern edge is said to be so sharp as to improve the resolution.

In the prior art technique, however, only photomask adapted for periodical patterns such as L & S patterns as well as photomasks adapted for positive resists and for isolated patterns have been known. Thus, no photomasks adapted for negative resists and for isolated patterns to form spaces or holes with have been known.

The use of the above-mentioned conventional photomasks for positive resists to form so fine isolated patterns, such as space patterns and hole patterns, as to be near the resolution limit entails not only a fall in the light intensity of projection pattern but also a widening of the light intensity profile, leading to a difficulty in forming a resist pattern with feature sizes in conformity with the design thereof. For the same reason as mentioned above, the side walls of the resist pattern cannot be perpendicular to the surface of a wafer.

In contrast, photomasks for negative resist are advantageous in that a problem of a decrease in the light intensity of a projection pattern does not arise since areas subjected to light exposure are outside a mask pattern.

An object of the present invention is to provide a phase-shifting photomask for a negative resist which is used to form an isolated pattern and is excellent in resolution and focus margin.

The foregoing object has been attained by providing the following photomasks and process.

In accordance with one aspect of the present invention, there is provided a photomask adapted to be used in a projection aligner to project the mask pattern thereof in the form of an isolated pattern on the surface of a wafer having a negative resist film formed thereon, comprising:

a substrate transparent to an exposure light, and

a mask pattern provided on the above-mentioned substrate;

wherein the above-mentioned mask pattern is formed of a phase-shifting layer capable of transmitting the exposure light therethrough and shifting the phase of the exposure light transmitted therethrough relatively to the phase of the exposure light transmitted through the area of the photomask other than the area of the phase-shifting layer.

According to the foregoing embodiment of the present invention, the light transmitted through the phase-shifting layer interferes with the light transmitted through the area of the photomask other than the area of the phase-shifting layer to lower the light intensity just on the surface of the wafer (the term "surface of the wafer" represents the surface of the wafer itself or surface of the resist provided on the surface of the wafer) below the phase-shifting layer to such an extent as to leave the resist in a still substantially soluble state, with the result that such a fine isolated resist pattern as to exceed the resolution limit can be formed. Accordingly, the focus margin is improved as well.

In carrying out this embodiment of the present invention, the mask pattern formed of the phase-shifting layer is preferably in a striped form to thereby enable the mask pattern to be projected as the isolated pattern on the surface of the wafer to form a space pattern in the form of the isolated pattern in the negative resist.

Also in carrying out this embodiment of the present invention, the mask pattern formed of the phase-shifting layer is preferably in a quadrate form to thereby enable the mask pattern to be projected as the isolated pattern on the surface of the wafer to form a hole pattern in the form of the isolated pattern in the negative resist.

Further, in carrying out this embodiment of the present invention, the width W of the mask pattern formed of the phase-shifting layer is preferably such as to be expressed by the following equation:

$$W = P\frac{\lambda}{NA}$$

wherein $0 < P \leq 0.6$, NA stands for the numerical aperture of the projection aligner, and $\lambda$ stands for the wavelength of the exposure light.

Still further, in carrying out this embodiment of the present invention, the thickness d of the mask pattern formed of the phase-shifting layer is preferably such as to be expressed by the following equation:

$$d = (\ell + k)\lambda/(n - 1)$$

wherein $1/4 \leq k \leq 3/4$, $\lambda$ stands for the wavelength of the exposure light, n stands for the refractive index at $\lambda$ of the phase-shifting layer, and $\ell$ is 0 or a positive integer.

In accordance with another aspect of the present invention, there is provided a photomask adapted to be used in a projection aligner to project the mask pattern thereof in the form of an isolated pattern on the surface of a wafer having a negative resist film formed thereon, comprising:

a substrate transparent to an exposure light, and

a mask pattern provided on the above-mentioned substrate;

wherein the above-mentioned mask pattern is constituted of a light-screening layer (or an opaque layer) and a phase-shifting layer, the light-screening layer being incapable of transmitting an exposure light therethrough and having a width permitting of no resolution by itself, and the phase-shifting layer being capable of transmitting the exposure light therethrough and shifting the phase of the exposure light transmitted therethrough relatively to the phase of the exposure light transmitted through the area of the photomask other than the area of the phase-shifting layer; and

wherein the phase-shifting layer with one and the same width is provided in contact with the light-screening layer in such a way as to at least substantially surround the light-screening layer.

According to the above-mentioned embodiment of the present invention, the light transmitted through the phase-shifting layer provided around the light-screening layer interferes with the light transmitted through the area of the photomask other than the area of the phase-shifting layer to lower the light intensity just on the surface of the wafer below the light-screening layer to such an extent as to leave the resist in a still substantially soluble state, with the result that such a fine isolated resist pattern as to exceed the resolution limit can be formed with excellent resolution and focus margin.

In carrying out this embodiment of the present invention, it is preferable that the light-screening layer be

3

in a striped form and that the phase-shifting layer be constituted of first and second striped phase-shifting layer areas separately disposed on the respective sides of the light-screening layer, whereby the mask pattern can be projected as the isolated pattern on the surface of the wafer to form a space pattern in the form of the isolated pattern in the negative resist film.

In carrying out this embodiment of the present invention, it is preferable that the light-screening layer be in a quadrate form and that the phase-shifting layer be disposed all around the light-screening layer, whereby the mask pattern can be projected as the isolated pattern on the surface of the wafer to form a hole pattern in the form of the isolated pattern in the negative resist film.

Further, in carrying out this embodiment of the present invention, the thickness d of the phase-shifting layer is preferably such as to be expressed by the following equation:

$$d = (\ell + k) \lambda/(n - 1)$$

wherein $1/4 \leq k \leq 3/4$, $\lambda$ stands for the wavelength of the exposure light, n stands for the refractive index at $\lambda$ of the phase-shifting layer, and $\ell$ is 0 or a positive integer.

In accordance with still another aspect of the present invention, there is provided a photomask adapted to be used in a projection aligner to project the mask pattern thereof in the form of an isolated pattern on the surface of a wafer having a negative resist film formed thereon, comprising:

a substrate transparent to an exposure light, and

a mask pattern provided on the above-mentioned substrate;

wherein the above-mentioned mask pattern is formed of a light-screening layer (or an opaque layer) and a phase-shifting layer, the light-screening layer being incapable of transmitting an exposure light therethrough, and the phase-shifting layer being capable of transmitting the exposure light therethrough and shifting the phase of the exposure light transmitted therethrough relatively to the phase of the exposure light transmitted through the area of the photomask other than the area of the phase-shifting layer;

wherein the phase-shifting layer is provided in such a way as to fill up an auxiliary aperture provided in the light-screening layer;

wherein the portion of the phase-shifting layer with which the auxiliary aperture is filled up has a width permitting of no resolution by itself; and

wherein the areas of the light-screening layer respectively existing around sides of the phase-shifting layer and in the width-wise direction of the phase-shifting layer have one and the same width.

According to this embodiment of the present invention, the light-screening layer, even when so fine as to permit of no resolution by itself, the light transmitted through the phase-shifting layer filling up the auxiliary aperture of the light-screening layer interferes with the light transmitted through the area of the photomask on the outside of the light-screening layer to lower the light intensity just on the surface of the wafer under the light-screening layer including the phase-shifting layer filling up the auxiliary aperture to such an extent as to leave the resist in a still substantially soluble state, with the result that such a fine isolated resist pattern as to exceed the resolution limit can be formed with excellent resolution and focus margin.

In carrying out this embodiment of the present invention, the light-screening layer and the phase-shifting layer are both preferably in a quadrate form to thereby enable the mask pattern to be projected as the isolated pattern on the surface of the wafer to form a hole pattern in the form of the isolated pattern in the negative resist film.

Also in carrying out this embodiment of the present invention, the light-screening layer and the phase-shifting layer are both preferably in a striped form to thereby enable the mask pattern to be projected as the isolated pattern on the surface of the wafer to form a space pattern in the form of the isolated pattern in the negative resist film.

Further, in carrying out this embodiment of the present invention, the thickness d of the phase-shifting layer is preferably such as to be expressed by the following equation:

$$d = (\ell + k) \lambda/(n - 1)$$

wherein $1/4 \leq k \leq 3/4$, $\lambda$ stands for the wavelength of the exposure light, n stands for the refractive index at $\lambda$ of the phase-shifting layer, and $\ell$ is 0 or a positive integer.

In any one of the foregoing embodiment of the present invention, the amount of optical phase shift by the phase-shifting layer is preferably 180°.

In accordance with a further aspect of the present invention, there is provided a process for forming a resist image in the form of an isolated pattern using a photomask according to any one of the foregoing embodiments, comprising the step of applying a negative resist on an underlying surface, the step of exposing the negative resist through the photomask for use in projection of an isolated pattern to an exposure light, and the step of developing the light-exposed negative resist.

According to this process of the present invention, such a fine isolated negative resist pattern as to

4

exceed the resolution limit can be easily and simply formed.

The foregoing and other objects, features and advantages of the present invention will be better understood from the following description taken in connection with the accompanying drawings, in which:

Fig. 1 is a schematic partial cross-sectional view of a conventional phase-shifting photomask for periodical resist pattern formation;

Figs. 2(a) and 2(b) are schematic partial cross-sectional views of conventional phase-shifting photomasks for positive resist which are used to form a space pattern and a hole pattern, respectively;

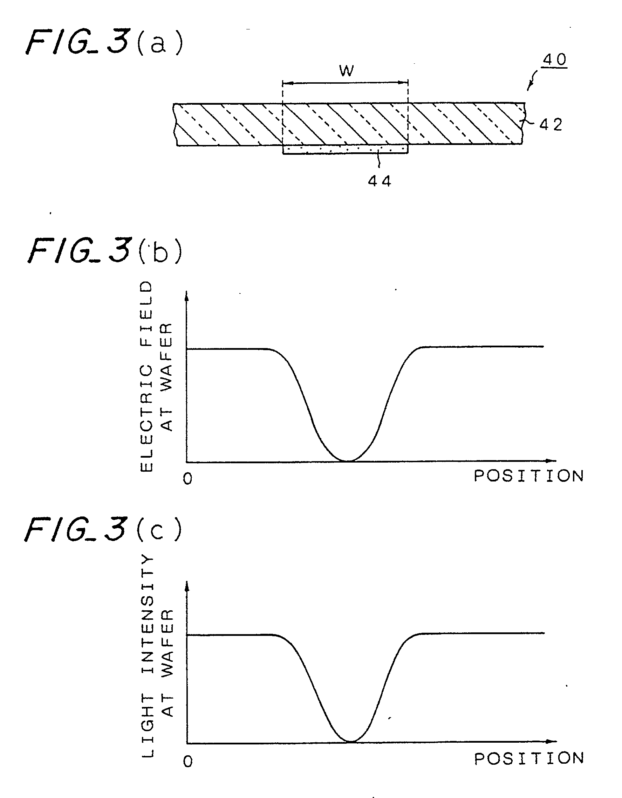

Figs. 3(a) to 3(c) are illustrations concerning an example of the phase-shifting photomask of the present invention for a negative resist designed to be used to form an isolated pattern, of which Fig. 3(a) is a schematic partial cross-sectional view of the photomask, Fig. 3(b) is an electric field profile, on the surface of a wafer, of a light transmitted through the photomask, and Fig. 3(c) is a light intensity profile, on the surface of the wafer, of the light transmitted through the photomask;

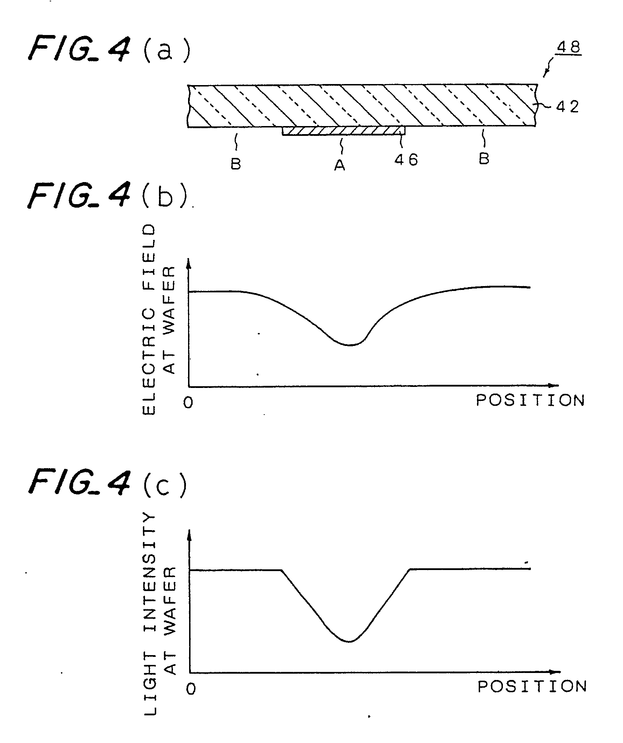

Figs. 4(a) to 4(c) are illustrations concerning a comparative photomask and aimed at facilitating the understanding of the behavior of the light transmitted through the phase-shifting photomask of Fig. 3(a) by comparison, of which Fig. 4(a) is a schematic partial cross-sectional view of the photomask, Fig. 4(b) is an electric field profile, on the surface of a wafer, of a light transmitted through the photomask, and Fig. 4(c) is a light intensity profile, on the surface of the wafer, of the light transmitted through the photomask;

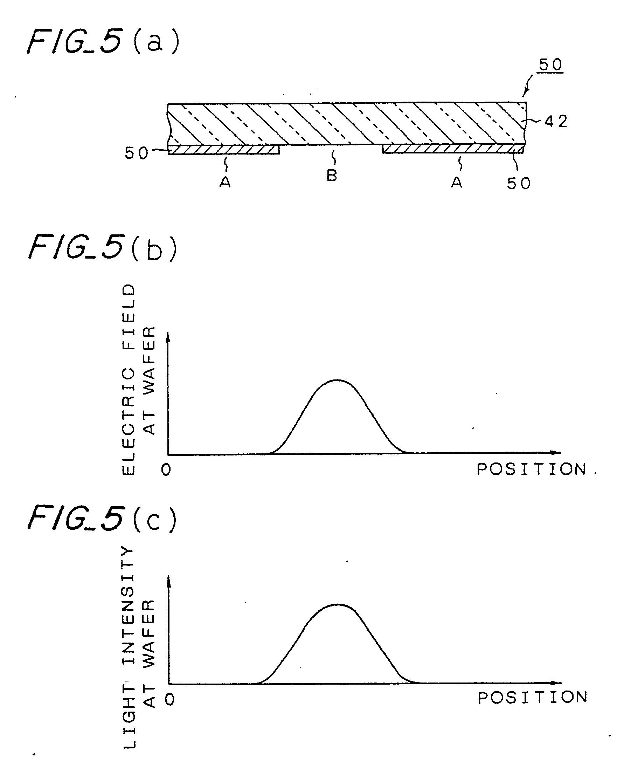

Figs. 5(a) to 5(c) are illustrations concerning another comparative photomask and aimed at facilitating the understanding of the behavior of the light transmitted through the phase-shifting photomask of Fig. 3(a) by comparison, of which Fig. 5(a) is a schematic partial cross-sectional view of the photomask, Fig. 5(b) is an electric field profile, on the surface of a wafer, of a light transmitted through the photomask, and Fig. 5(c) is a light intensity profile, on the surface of the wafer, of the light transmitted through the photomask;

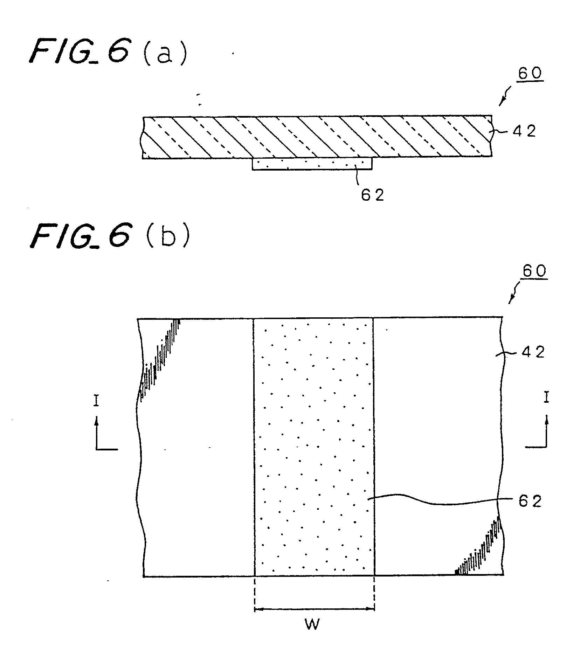

Figs. 6(a) and 6(b) are a schematic partial cross-sectional view taken along line I - I of Fig. 6(b) and a schematic partial plan view, respectively, of a phase-shifting photomask for space pattern formation as one mode of the phase-shifting photomask of Fig. 3(a) according to the present invention;

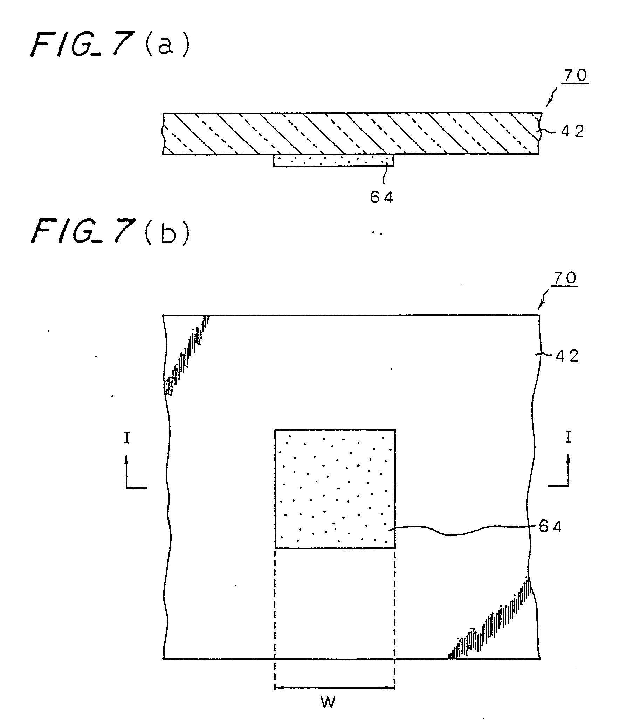

Figs. 7(a) and 7(b) are a schematic partial cross-sectional view taken along line I - I of Fig. 7(b) and schematic partial plan view, respectively, of a phase-shifting photomask for hole pattern formation as another mode of the phase-shifting photomask of Fig. 3(a) according to the present invention;

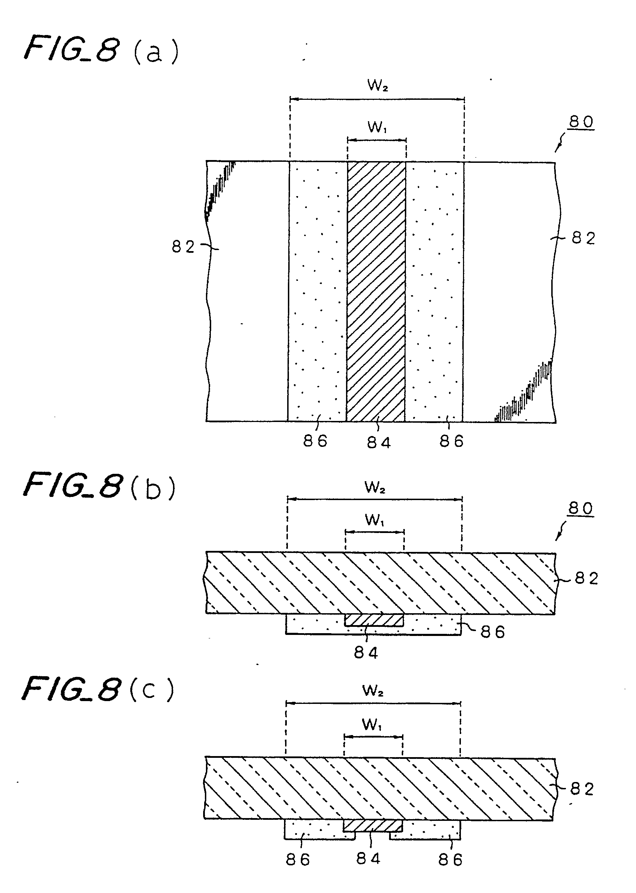

Figs. 8(a) to 8(c) are schematic diagrams of three different modes of another example of the phase-shifting photomask of the present invention for a negative resist, designed to be used to form a space pattern as an isolated pattern and having a structure comprising a light-screening or opaque layer and a phase-shifting layer(s) provided at least on both sides of the light-screening layer of which Fig. 8 (a) is a partial cross-sectional view of a phase-shifting photomask, Fig. 8(b) is a partial plan view of another phase-shifting photomask, and Fig. 8(c) is a partial plan view of still another phase-shifting photomask;

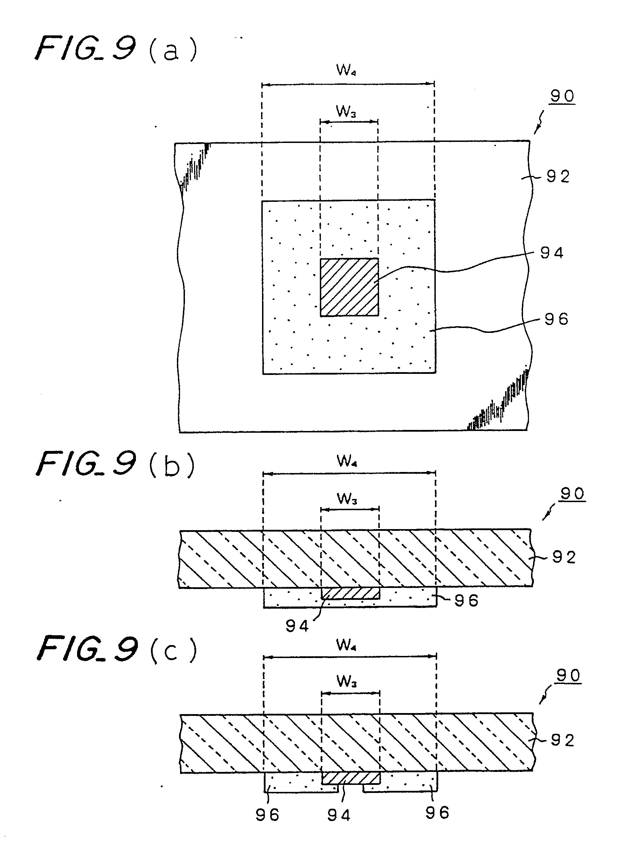

Figs. 9(a) to 9(c) are schematic diagrams of three different modes of another example of the phase-shifting photomask of the present invention for a negative resist, designed to be used to form a hole pattern as an isolated pattern and having a structure comprising a light-screening or opaque layer and a phase-shifting layer provided at least around the light-screening layer of which Fig. 9 (a) is a partial cross-sectional view of a phase-shifting photomask, Fig. 9(b) is a partial plan view of another phase-shifting photomask, and Fig. 9(c) is a partial plan view of still another phase-shifting photomask;

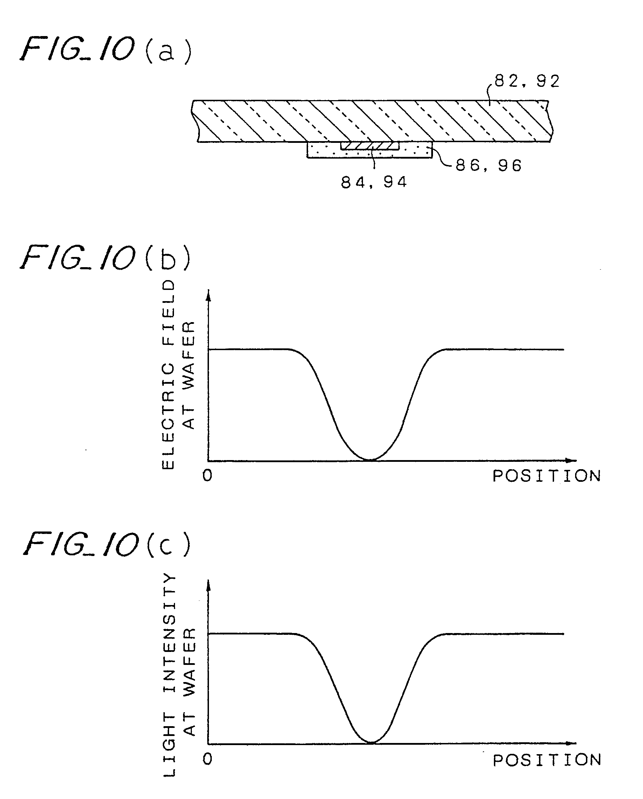

Figs. 10(a) to 10(c) are illustrations aimed at facilitating the understanding of the behavior of the light transmitted through any one of the phase-shifting photomask of Figs. 8 and 9, of which Fig. 10(a) is a schematic partial cross-sectional view of the photomask, Fig. 10(b) is an electric field profile, on the surface of a wafer, of a light transmitted through the photomask, and Fig. 10(c) is a light intensity profile, on the surface of the wafer, of the light transmitted through the photomask;

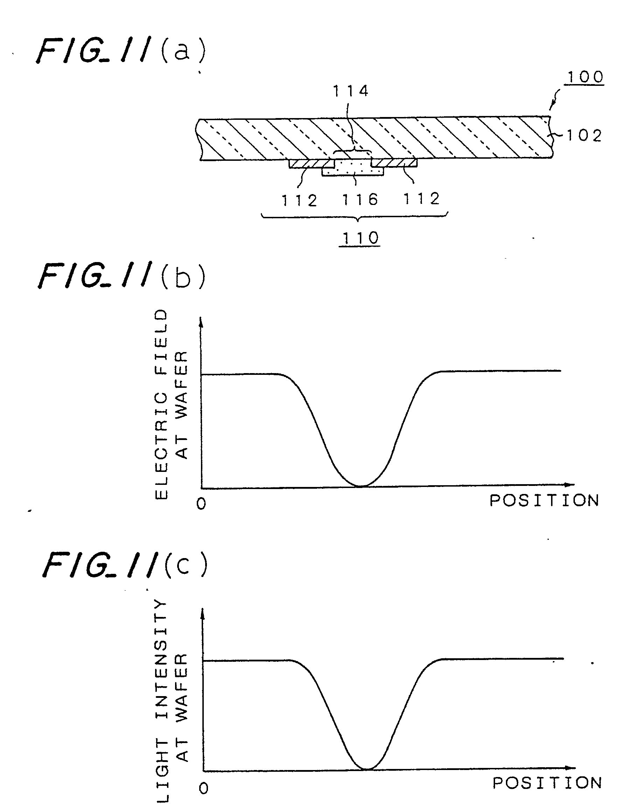

Fig. 11(a) to 11(c) are illustrations concerning still another example of the phase-shifting photomask of the present invention for a negative resist, having a structure comprising a light-screening or opaque layer with an auxiliary aperture and a phase-shifting layer provided in such a way as to fill up therewith the light-screening layer, of which Fig. 11(a) is a schematic partial cross-sectional view of the photomask, Fig. 11(b) is an electric field profile, on the surface of a wafer, of a light transmitted through the photomask, and Fig. 11(c) is a light intensity profile, on the surface of the wafer, of the light transmitted through the photomask.

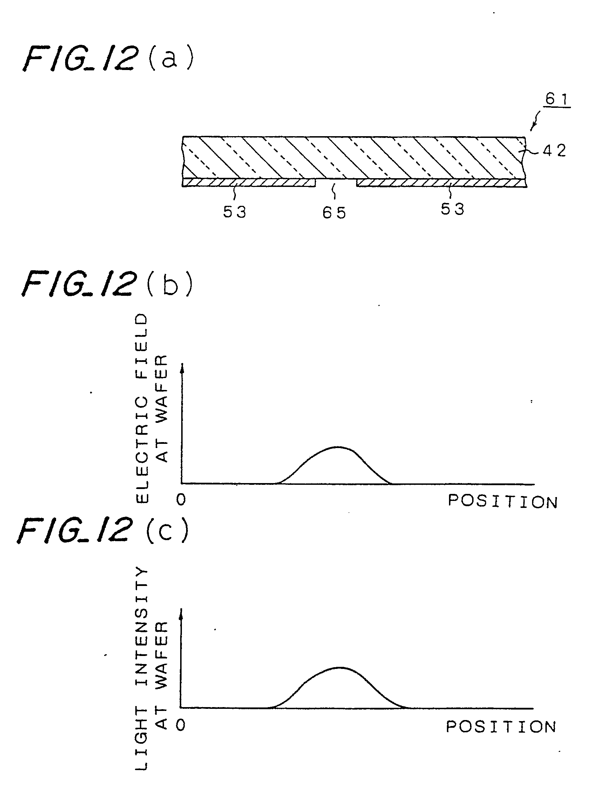

Figs. 12(a) to 12(c) are illustrations concerning a comparative photomask and aimed at facilitating the understanding of the behavior of the light transmitted through the phase-shifting photomask of Fig. 11(a) by comparison, of which Fig. 12(a) is a schematic partial cross-sectional view of the photomask, Fig. 12(b) is an electric field profile, on the surface of a wafer, of a light transmitted through the photomask, and Fig. 12-(c) is a light intensity profile, on the surface of the wafer, of the light transmitted through the photomask;

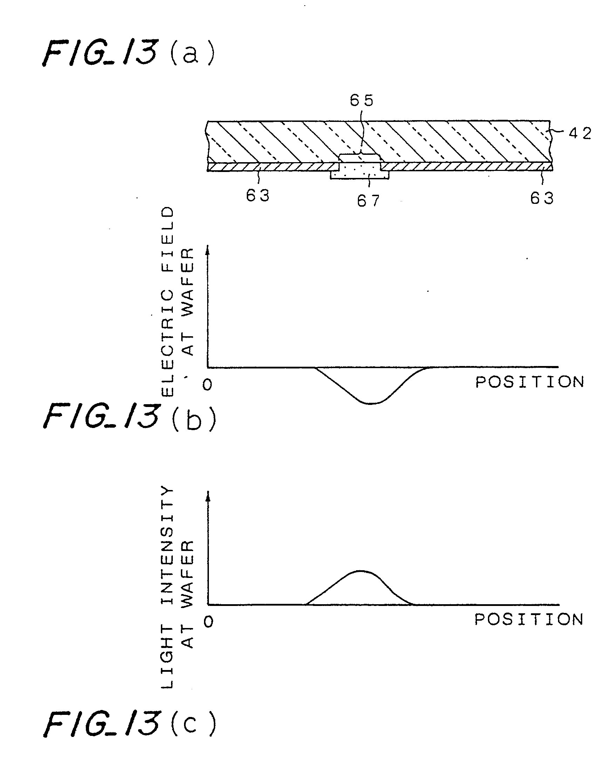

Figs. 13(a) to 13(c) are illustrations concerning another comparative photomask and aimed at facilitating the understanding of the behavior of the light transmitted through the phase-shifting photomask of Fig. 11(a) by comparison, of which Fig. 13(a) is a schematic partial cross-sectional view of the photomask, Fig. 13(b) is an electric field profile, on the surface of a wafer, of a light transmitted through the photomask, and Fig. 13(c) is a light intensity profile, on the surface of the wafer, of the light transmitted through the photomask;

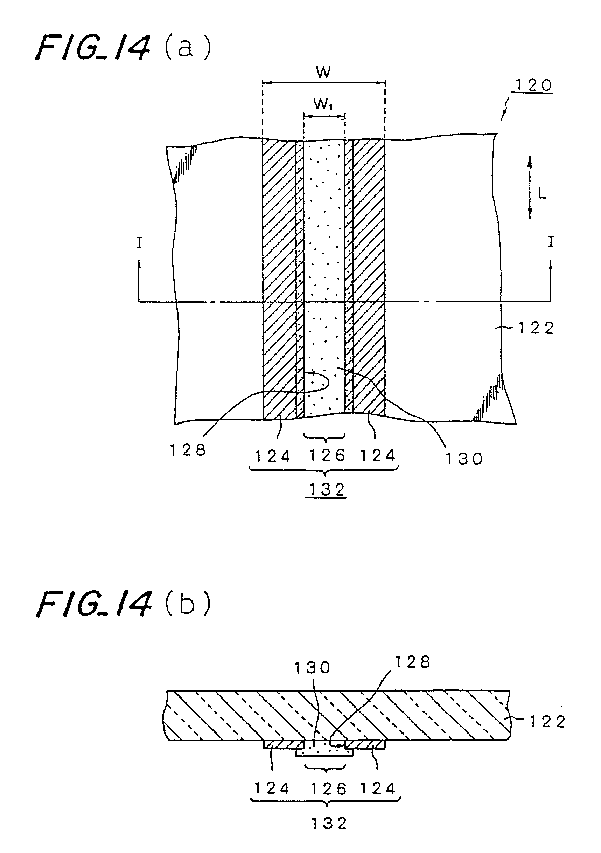

Fig. 14(a) and 14(b) are schematic illustrations of a specific instance of the phase-shifting photomask of Fig.11(a), of which Fig. 14(a) is a partial plan view of a photomask for space pattern formation, and Fig. 14(b) is a partial cross-sectional view of the photomask, taken along line I-I of Fig. 14(a);

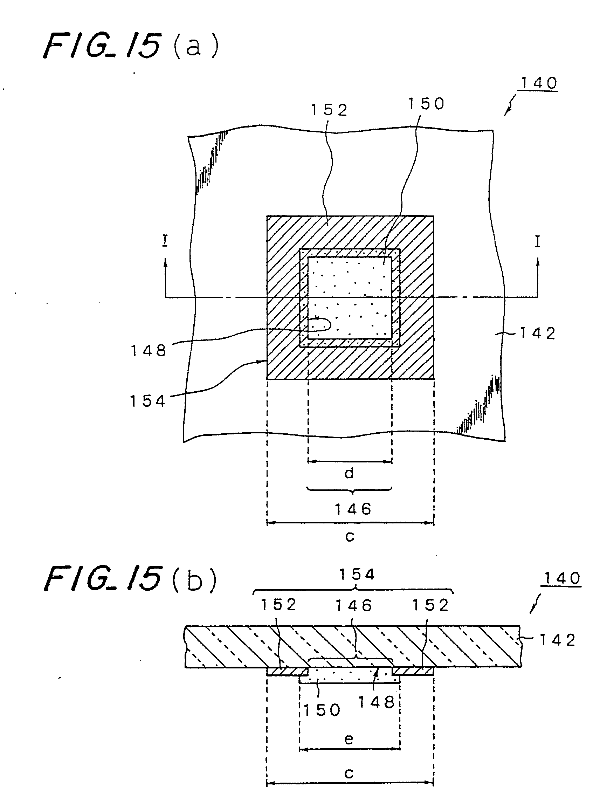

Fig. 15(a) and 15(b) are schematic illustrations of another specific instance of the phase-shifting photomask of Fig.11(a), of which Fig. 15(a) is a partial plan view of a photomask for hole pattern formation, and Fig. 15(b) is a partial cross-sectional view of the photomask, taken along line I-I of Fig. 15(a) ; and

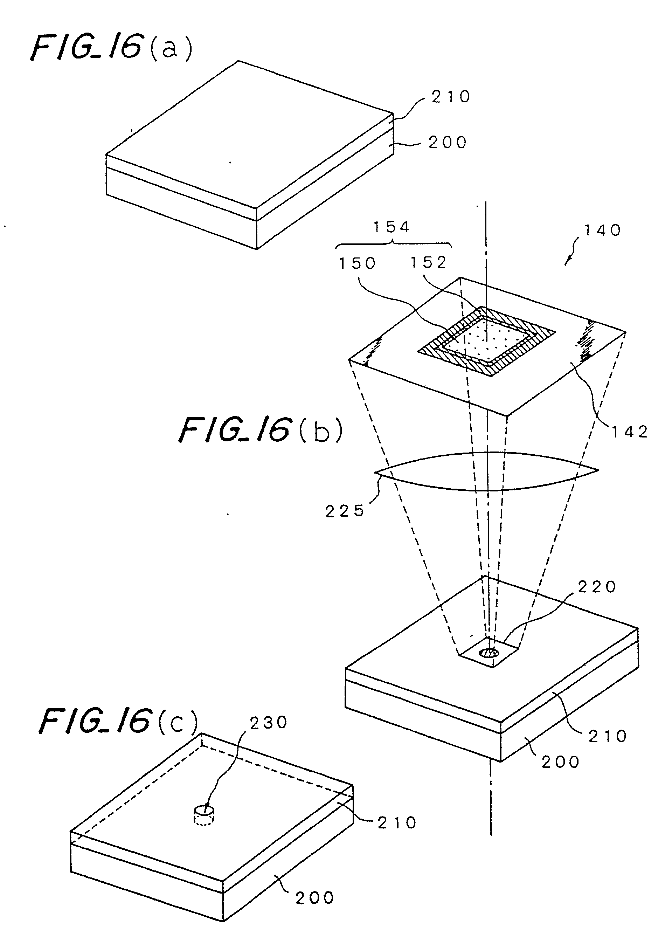

Figs. 16(a), 16(b) and 16(c) are process diagram for explaining a process for forming resist image in the form of an isolated pattern using one example of the photomask of the present invention.

Examples according to the present invention will now be described while referring to the accompanying drawings, in which the shapes and sizes of constituents as well as the positional relationships therebetween are shown so schematically as to only facilitate the understanding of the present invention, and hence should not be construed as limiting the scope of the present invention.

Example 1

Example 1 according to the present invention will be described while referring to Figs. 3 to 7.

Fig. 3(a) shows the cross-sectional structure of the principal part of a photomask 40 according to Example 1 of the present invention. In the photomask 40 of this Example for a negative resist to be used in photolithography according to the optical projection exposure process, a mask pattern for isolated pattern formation is formed of a thin film capable of shifting the phase of a light and made of, for example, $SiO_2$ or $Si_3N_4$ instead of a common Cr pattern (opaque layer). This film is hereinafter referred to as a "phase-shifting layer". This photomask 40 comprises a substrate 42 in the form of a quartz substrate or the like and the phase-shifting layer 44 provided on the substrate the phase-shifting layer 44 shifts the phase of a light transmitted therethrough by 180° relatively to the phase of a light transmitted through the area of the photomask 40 other than the area of the light-screening layer 44. Additionally stated, the term "photomask" used herein means one including a reticle.

A description will be made of the principle of Example 1. Now, a thought will be bestowed on the behaviors of both a light being transmitted through the phase-shifting layer 44 and a light transmitted through the area of the photomask 40 other than the area of the phase-shifting layer 44. For facilitating the understanding of those behaviors, reference will be made to a photomask 48 with a structure of Fig. 4(a) and a photomask 52 with a structure of Fig. 5(a). The photomask 48 as shown in Fig. 4(a) has a substrate 42 provided thereon with an opaque layer 46 with a width close to the resolution limit instead of the phase-shifting layer 44 in the case of the photomask 40 to form a light-screening area A and light-transmitting area B. Figs. 4(b) and 4(c) show the electric field versus position characteristic curve and light intensity versus position characteristic curve, respectively, of the light transmitted through the photomask 48 onto a wafer. As shown in Fig. 4(c), the light intensity is increased below the Cr pattern 46 because of light diffraction. On the other hand, the photomask 52 as shown in Fig. 5(a) has a substrate 42 provided thereon with a light-screening layer(s) or an opaque layer(s) 50 to form light-screening areas A and a light-transmitting area B in a positional relationship just reverse to that of Fig. 4(a). Accordingly, the width of the light-screening area A in Fig. 4(a) is the same as the width of the light-transmitting area B in Fig. 5(a). Figs. 5(b) and 5(c) show the electric field versus position characteristic curve and light intensity versus position characteristic curve, respectively, of the light transmitted through the photomask 52 onto a wafer. In this case, the light intensity is increased under the light transmitting area B as shown Fig. 5(c) because of light diffraction.

The photomask 40 of this example according to the present invention as shown in Fig. 3(a) corresponds to a structure wherein the phase of a light as in the case of Fig. 5 is reversed to allow that light to interfere with a light as in the case of Fig. 4. The use of the photomask 40 for a negative resist according to the present invention as shown in Fig. 3(a) makes a light transmitted through the phase-shifting layer 44 reversed in phase to interfere with a light transmitted through the area of the photomask other than the area of the phase-shifting layer 44, with the result that the light intensity below the phase-shifting layer 44 is lowered. As a result, a light intensity profile as shown in Fig. 3(c) is obtained. Therefore, a resist on a wafer [both are not shown in Fig. 3(a)] is not photosensitized in a center area thereof in the width wise direction below the phase-shifting layer 44. In the center area, the light intensity is rendered to substantial zero. This

6

enables a fine pattern to be formed.

In carrying out the present invention, the thickness of the phase-shifting layer is set to satisfy the following equation (1):

$$d = (\ell + k)\,\lambda/(n - 1) \qquad (1)$$

wherein d stands for the thickness of the phase-shifting layer 44, $\lambda$ stands for the wavelength of an exposure light, and n stands for the refractive index of the phase-shifting layer 44 as measured at the wavelength of the exposure light. The value of k may be in the range : $1/4 \leq k \leq 3/4$, but is preferably 1/2, while the value of $\ell$ may be 0 or a positive integer but is preferably 0. When k = 1/2 and $\ell$ = 0, the value of d can be expressed by the following equation:

$$d = \frac{\lambda}{2(n - 1)}$$

When the width W of the phase-shifting layer 44 is large, a light from the area of the photomask 40 other than the area of the phase-shifting layer 44 provides an intensity of zero in an area below the phase-shifting layer 44, while a light transmitted through the phase-shifting layer 44 has an intensity of its own without interference, with the result that the light intensity below the phase-shifting layer 44 is too large to provide the effect of Example 1 according to the present invention.

Accordingly, in carrying out the present invention, the width W of the phase-shifting layer 44 is set suitably with p = 0.6 or less in the following equation (2) in the case of a space pattern and a hole pattern.

$$W = P\,\tfrac{\lambda}{NA} \qquad (2)$$

wherein W stands for the width of the phase-shifting layer 44, $\lambda$ stands for the wavelength of the exposure light, and NA stands for the numerical aperture of a projection aligner.

Photomasks for negative resists to form a space pattern and a hole pattern with are drawn in figures.

Figs. 6(a) and 6(b) are a cross-sectional view and a plan view, respectively, showing the principal part of a photomask 60 for a negative resist according to Example 1 of the present invention, which is used to form a space pattern.

Figs. 7(a) and 7(b) are a cross-sectional view and a plan view, respectively, showing the principal part of a photomask 70 for a negative resist according to Example 1 of the present invention, which is used to form a hole pattern.

a) Trial Production of Photomask (Reticle)

An electron beam-sensitive resist OEBR-100 (trade name of a product manufactured by Tokyo Ohka Kogyo Co., Ltd.) to form a phase-shifting layer was applied on a quartz substrate 42 of five inches square (127 mm square and 2.3 mm thick) with a reticle alignment mark by spin coating at 3,000 rpm, and subjected to writing exposure with an electron beam exposure apparatus.

Subsequently, the exposed resist was developed with a special developing solution and post-baked. The remaining resist film to serve as a phase-shifting layer 62 or 64 in a striped or quadrate form as shown in Fig.6 or 7 by marking it with dots, respectively, had a thickness of 3,000 Å.

b) Trial Patterning

The reticle formed in the foregoing step was subjected to trial patterning using an i-line stepper of 1/10 in reduction with NA = 0.42.

A high-resolution negative resist LMR-UV (a product in a trade name "FSMR" manufactured by Fuji Yakuhin K.K.) was applied on an Si substrate of three inches in diameter by spin coating to form a resist layer having a thickness of 1.0 $\mu$m, which was then baked on a hot plate at 70$^\circ$C for 1 minute.

Subsequently, the reticle and the Si substrate were set in an stepper and exposed to a light while independently varying the amount of light exposure and the focus. Thereafter, the wafer (Si substrate) was baked on a hot plate at 110$^\circ$C for 1 minute and subjected to development with a special developing solution for LMR-UV.

Thereafter, the measurement of feature sizes and the observation were carried out using a scanning electron microscope(SEM).

(i) Space Pattern

When the amount of light exposure was 200 mJ/cm², a striped phase-shifting pattern of 2 μm in width W on the reticle was translated (reproduced) into a space pattern of 0.2 μm in width on the Si substrate. This space pattern was resolved over a depth of focus of 1.5 μm. With the same amount of light exposure as mentioned above, a striped phase-shifting pattern of 2.5 μm in width W on the reticle was translated into a space pattern of 0.25 μm in width on the Si substrate. This space pattern was resolved over a depth of focus of 1.8 μm.

(ii) Hole Pattern

When the amount of light exposure was 140 mJ/cm², a phase-shifting pattern 3.0 μm square on the reticle was resolved into a hole pattern of 0.3 μm in diameter on the Si substrate. This hole pattern was resolved over a depth of focus of 1.2 μm.

(iii) Conventional Cr Pattern

For comparison, the substantially the same experiment as described above was repeated using a reticle with a common Cr pattern as a light-screening (or opaque) layer.

An amount of light exposure and a depth of focus enabling a Cr pattern of 2.5 μm in width on the reticle to be translated into a space pattern of 0.25 μm in width on the Si substrate could not be found. Even at a depth of focus which has been believed to be best, no space pattern was resolved altogether with an amount of light exposure of 160 mJ/cm² while a space pattern of 0.3 μm was formed with an amount of light exposure of 150 mJ/cm². A Cr pattern of 3 μm in width on the reticle was translated into a space pattern of 0.3 μm in width when the amount of light exposure was 180 mJ/cm². The depth of focus at which this Cr pattern was resolved was 0.6 μm. A Cr pattern 3 μm square on the reticle for a hole pattern was not resolved at all.

As is apparent from the foregoing results, the photomask of the present invention for a negative resist can improve the focus margin and enables fine space as well as hole pattern as an isolated pattern beyond the common resolution limit to be formed on an Si substrate.

Example 2

Example 2 according to the present invention will be described while referring to Figs. 8 to 10.

In a photomask 80, 90 of Example 2 for a negative resist according to the present invention which is an application example of Example 1, a mask pattern so fine as to exceed the resolution limit is constituted of a Cr pattern as a light-screening (or opaque) layer 84, 94 formed on a substrate 80, 90 and a phase-shifting layer 86, 96 formed around the light-screening layer.

Figs. 8(a) to 8(c) are illustrations of the principal part of various types of photomasks of Example 2 for space pattern formation according to the present invention. Fig. 8(a) is a plan view of a photomask, while Figs. 8(b) and 8(c) are cross-sectional views of other photomasks. In the case of a common photomask, a pattern incapable of light transmission, such as a Cr pattern, is formed all over the width $W_2$. The width $W_2$ of a Cr line is translated into a width m x $W_2$ on a wafer when the reduction of a stepper is m (e.g., 1/5 or 1/10). In contrast, a line pattern with the width $W_2$ in this example is constituted of a Cr pattern 84 with a width $W_1$ permitting of no resolution by itself and phase-shifting patterns 86 equal in width to each other which are respectively formed on the two sides of the Cr pattern 84 and in contact with the Cr pattern 84. In Fig. 8(a) the pattern 84 is shown by marking with oblique lines and pattern 86 by marking it with dots. In Fig. 8(a), phase-shifting layers 86 are formed in contact with the respective side walls of a Cr pattern 84. In Fig. 8(b) a phase-shifting layer 86 is formed in such a way as to cover a Cr pattern 84 and extend beyond both sides of the Cr pattern 84. In Fig. 8(c), phase-shifting layers 86 are respectively formed on the two sides of a Cr pattern 84 in such a way as to cover part of each side end area of the Cr pattern 84.

Figs. 9(a) to 9(c) are illustrations of the principal part of various types of photomasks of Example 2 for hole pattern formation according to the present invention. Fig. 9(a) is a plan view of a photomask, while Figs. 9(b) and 9(c) are cross-sectional views of other photomasks. In the case of a common photomask, a Cr or like pattern is formed all over a square with its sides of $W_4$ in length on a substrate, and is translated,

8

or reproduced, into a hole pattern of m x $W_4$ in diameter. In contrast, a mask pattern with its sides of $W_4$ in length for hole pattern formation in this Example is constituted of a Cr pattern 94 with its sides of $W_3$ in length patterning of no resolution by itself and a phase-shifting pattern 96 formed therearound, which are both formed on a substrate 92. In Fig. 9(a), the pattern 94 is shown by marking it with oblique lines and pattern 96 by marking it with dots. In Fig. 9(a) an annular quadrate-contoured phase-shifting layer 96 with one and the same width is formed around a quadrate Cr pattern 94 as a light-screening (or opaque) layer and in contact with the Cr pattern 94. In Fig. 9(b), a quadrate-coutoured phase-shifting layer 96 larger than a Cr pattern 94 is formed in such a way as to cover all the Cr pattern 94 in the central area. In Fig.9(c), an annular quadrate-coutoured phase-shifting layer 96 with one and the same width is formed around a quadrate Cr pattern 94 in the central area in such a way as to cover the peripheral area of the Cr pattern 94.

Additionally stated, the material of the phase-shifting layer may be an $SiO_2$ film, an $Si_3N_4$ film, or the like just like in Example 1.

a) Trial Production of Photomasks (Reticles)

Reticles for space or hole pattern formation as schematically shown in Figs. 8 and 9 were produced on trial with respective varied dimensions ($W_1$, $W_2$, $W_3$ and $W_4$), specific values of which are listed in Tables 1 and 2.

Table 1

| $W_1$ and $W_2$ in Reticle for Space Pattern | |
| --- | --- |
| $W_1$ [$\mu$m] | $W_2$ [$\mu$m] |
| 1.0 | 2.0 |
| 1.0 | 2.5 |
| 1.0 | 3.0 |
| 1.5 | 2.5 |
| 1.5 | 3.0 |
| 2.0 | 3.0 |

9

Table 2

| W₃ and W₄ in Reticle for Hole Pattern | |
|---|---|
| $W_3$ [$\mu$m] | $W_4$ [$\mu$m] |
| 1.0 | 3.0 |
| 1.0 | 4.0 |
| 1.0 | 5.0 |
| 1.5 | 3.0 |
| 1.5 | 4.0 |
| 1.5 | 5.0 |
| 2.0 | 3.0 |
| 2.0 | 4.0 |
| 2.0 | 5.0 |
| 3.0 | 4.0 |
| 3.0 | 5.0 |
| 4.0 | 5.0 |

In this trial production, every phase-shifting layer, which had a thickness of 3,000 Å, was formed from an electron beam-sensitive negative resist OEBR-100 (trade name of a product manufactured by Tokyo Ohka Kogyo Co., Ltd.). The above-mentioned thickness satisfies such conditions as to cause a shift by 180° of the optical phase of an i-line exposure light as used in trial patterning which will be described later. While every mask pattern 80, 90 formed in this trial production is such as to have a Cr pattern 84, 94 covered all over with a phase-shifting layer 86, 96 as shown in Figs. 8(b) and 9(b), even formation of a mask pattern as shown either in Figs. 8(a) and 8(c) or in Fig. 9(a) and 9(c) involves no problems as well.

The procedure of trial production is as follows. First, a Cr pattern 84, 94 is formed on a quartz substrate as a substrate 82, 92 according to a customary method. In this step, an alignment mark (not shown in the figures) instrumental in formation of a phase-shifting pattern is also formed.

Subsequently, the negative resist ia applied all over the surface of the substrate 82, 92 having the Cr pattern 84, 94 formed thereon by spin coating at 3,000 rpm to form a resist film of 5,500 Å in thickness, which is then subjected to writing with an electron lithography exposure tool on the basis of data produced according to CAD. Subsequently, the resist film is developed and post-baked. According to the foregoing procedure, the thickness of the remaining resist film(s) as a phase-shifting layer(s) 86, 96 was 3,000 Å.

b) Trial Patterning

The reticles produced according to the foregoing procedure were used in combination with an i-line stepper of 1/10 in reduction with NA = 0.42 to carry out trial patterning.

First, a 1.0 $\mu$m-thick film of a high-resolution negative resist LMR-UV (a product manufactured by Fuji Yakuhin K.K.) was formed on an Si substrate of 3 inches in diameter by spin coating, and then baked on a hot plate at 70° C for 1 minute.

Subsequently, the reticle and the Si substrate were set in the stepper, and the resist film was then exposed to a light while independently varying the amount of light exposure and the focus. Thereafter, the resist film on the Si substrate was baked on a hot plate at 110° C for 1 minute, and then developed with a special developing solution for LMR-UV.

Thereafter, the measurement of feature sizes and the observation were carried out with the SEM.

(i) Space Patterns

When the amount of light exposure was 180 mJ/cm², a mask pattern with $W_1$ = 1.0 $\mu$m and $W_2$ = 2.5 $\mu$m on the reticle was translated, or reproduced, into a 0.25 $\mu$m-wide space pattern. This space pattern was resolved over a depth of focus of 1.5 $\mu$m. With the same amount of light exposure, a mask pattern with $W_1$ = 1.5 $\mu$m and $W_2$ = 3.0 $\mu$m was translated into a 0.3 $\mu$m-wide space pattern on the Si substrate. This space pattern was resolved over a depth of focus of 2.0 $\mu$m. A mask pattern with $W_1$ = 1.0 $\mu$m and $W_2$ = 3.0 $\mu$m was resolved over a depth of focus of 2.4 $\mu$m. In the case of every other combination of $W_1$ with $W_2$ in the mask pattern for space pattern formation in Table 1, the resolution and the focus margin are presumed to have been within respective satisfactory ranges.

(ii) Hole Patterns

When the amount of light exposure was 140 mJ/cm², a mask pattern with $W_3$ = 1.0 $\mu$m and $W_4$ = 3.0 $\mu$m on the reticle was translated into a hole pattern of 0.3 $\mu$m in diameter. This hole pattern was resolved over a depth of focus of 1.2 $\mu$m. In the case of every other combination of $W_3$ and $W_4$ in the mask pattern for hole pattern formation in Table 2, the resolution and the focus margin are presumed to have been within respective satisfactory ranges.

(iii) Conventional Cr Pattern

For comparison, substantially the same experiment as described above was repeated using a reticle with a common Cr pattern alone as a light-screening (opaque) layer.

An amount of light exposure and a depth of focus enabling a Cr pattern of 2.5 $\mu$m in width on the reticle to be translated into a space pattern of 0.25 $\mu$m in width on an Si substrate could not be found. Even at a depth of focus which has been believed to be best, no space pattern was resolved at all with an amount of light exposure of 160 mJ/cm², while a space pattern of 3.3 $\mu$m in width was formed with an amount of light exposure of 150 mJ/cm². A Cr pattern of 3 $\mu$m in width on the reticle was translated, or reproduced, into a space pattern of 0.3 $\mu$m in width when the amount of light exposure was 180 mJ/cm². The depth of focus at which this Cr pattern was 0.6 $\mu$m.

A Cr pattern 3 $\mu$m square on the reticle for hole pattern formation was not resolved at all.

From the foregoing results, it can be concluded that the photomask of Example 2 for a negative resist according to the present invention is effective in improving the resolution and the focus margin.

The reason for this is as follows.

When use is made of a conventional photomask with a Cr pattern close to the resolution limit for a negative resist, the light intensity on the surface of a wafer comes to be so strong even in the area thereof below the light-screening Cr pattern because of light diffraction to give trouble in pattern formation [see Figs. 4(a) to 4(c)]. A resist is exposed even in the area thereof below the Cr pattern to the light deviated because of the diffraction to become insoluble in a developing solution with a failure in securing a desired pattern. On the other hand, a transmission pattern, even with a size of about 1/2 to 1/4 of the resolution limit, provides a light intensity profile as shown in Fig. 5(c). The deviated light as mentioned above corresponds to the light transmitted through the phase-shifting layer(s) 86, 96 disposed outside the Cr pattern 84, 94 in the mask pattern of the photomask of Example 2 according to the present invention [see Figs. 8(b) and 8-(c), and Figs. 9(b) and 9(c)]. The latter light is reversed in amplitude by shifting the optical phase thereof to make the amplitude thereof composited with the amplitude of the light in the case of the Cr pattern 84, 94 alone to provide a desirable light intensity profile with lowered light intensities in an area below the mask pattern as seen in Figs. 10(a) to 10(c). Thus, it can be concluded that the photomask of Example 2 according to the present invention not only enables formation of such a fine pattern as to exceed the resolution limit, but also is effective in improving the focus margin.

Example 3

Example 3 according to the present invention will be described while referring to Fig. 4 and Figs. 11 to 15.

In a photomask 100 of this Example as shown in Fig. 11(a), a mask pattern 110 for isolated pattern formation is formed on a substrate 102, and has a width close to or smaller than the resolution limit. The mask pattern 110 is constituted of a light-screening layer 112 and a phase-shifting layer 116 provided in such a way as to fill up therewith an auxiliary aperture 114 in the light-screening layer 112.

The principle of this Example is as follows.

As already described, when use is made of the photomask 48 provided with the light-screening layer 48 such a fine feature size as to be close to or smaller than the resolution limit, the light intensity on the surface of a wafer comes to be so strong even in an area thereof below the light-screening layer 46 because of light diffraction as to give trouble in pattern formation [see Fig. 4(c)]. Therefore, a negative resist is exposed to a light even in the area thereof below the light-screening layer 46 to become insoluble in a developing solution, with the result that the resist remains even in the above-mentioned area after development, leading to a failure in securing a desired pattern. In this case, the electric field profile on surface of a wafer is as shown in Fig. 4(b).

On the other hand, a photomask 61 having a light-transmitting area 65 with a width of only about 1/2 to 1/4 of the resolution limit and hence permitting of no resolution by itself between light-screening areas 63 as shown in Fig. 12(a) allows some light intensity to be manifested on an area of a wafer below the light-transmitting area 65 [see Fig. 12(c)], though the width of the light-transmitting area 65 is very small. In this case, the electric field profile on the surface of the wafer is as shown in Fig. 12(b). The width of the light-transmitting area 65 is set considerably smaller than the width of the light-screening layer 46 in Fig. 4(a) unlike in the case of the light-transmitting area B as already described in connection with Fig. 5(a). Here, when a phase-shifting thin film 67 capable of shifting the phase of a light transmitted therethrough by 180° is provided in the light-transmitting area 65 of the photomask 61 as shown in Fig. 13(a), the light transmitted through the phase-shifting thin film 67 is reversed in the phase of electric field on the surface of a wafer [see Fig. 13(b)] though the intensity thereof is substantially the same as in Fig. 12(c) [see Fig. 13(b)].

In the photomask 100 of Fig. 11(a) which is in the form of a combination of the structure of Fig. 4(a) with the structure of Fig. 13(a), therefore, the diffracted light below the light-screening area 112 is negated in intensity by the light transmitted through the phase-shifting thin film 116. This greatly weakens the intensity of light striking a resist in the area thereof below the light-screening area 112 to keep the above-mentioned area of the resist from becoming solution in a developing solution.

(i) Space Patterns

Figs. 14(a) and 14(b) are illustrations of this Example wherein a photomask 120 has a long mask pattern of W x L in area to form a space pattern as sn isolated pattern with. The photomask 120 in this Example is actually provided with a plurality of mask patterns differing in dimensions as listed in Table 3 (which will be given later). Fig. 14(a) is a schematic partial plan view of the photomask 120, while Fig. 14(b) is a schematic partial cross-sectional view of the photomask 120, taken along line I-I of fig. 14(a).

In the two figure, the photomask 120 comprises a substrate 122, which is usually formed of a quartz substrate, on which the mask pattern 132 for space pattern formation is provided. The mask pattern 132 is provided with an isolated light-screening (or opaque) pattern 124 of W x L in area which is in the form of striped light-screening layers in this case. In Fig. 14(a), the patterns 124 are shown by marking them with oblique lines. While a conventional photomask comprises a light-screening pattern formed of a material capable of screening an exposure light, such as a chrome film, over the whole range of width W, a light-transmitting area 126 having predetermined size and shape is provided in the light-screening pattern 124 in the present invention. Specifically, in this case of Example 3, the light-transmitting area 126 of $W_1$ ($W > W_1$) in width is disposed in the central area of the isolated light-screening pattern 124. Accordingly, the light-transmitting area 126 is structurally sandwiched between the equally wide portions of the light-screening pattern 124 arranged in the width-wise direction thereof (W direction). Additionally stated, the light-transmitting area 126, which is in a striped form like the isolated light-screening pattern 124, may extend either to a position close to the terminal end of the isolated light-screening pattern 124 or throughout the isolated light-screening pattern 124 in the length-wise direction thereof. In this case of Example 3, an auxiliary aperture 128 opened in the light-screening pattern 124 is filled up with a phase-shifting layer 130, the area of which corresponding to the auxiliary aperture 128 constitutes the light-transmitting area 126. In Fig. 14(a), the layer 130 is shown by marking it with dots.

In this photomask 120 of Example 3, the isolated light-screening pattern 124 and the light-transmitting area 126 (and hence the phase-shifting layer 130) are both 12,000 $\mu$m in length L. This photomask 120 is provided with a number of mask patterns differing in the width W of light-screening pattern 124 and in the width $W_1$ of light-transmitting area 126 (constituted of a phase-shifting layer 130), specific value of which are listed in the following Table 3. Additionally stated, when the reduction of a projection aligner is m (e.g. 1/5 or 1/10 ; incidentally, the value of m may be 1/1), an isolated pattern as a projected pattern on a resist measures m x (feature size on photomask).

Table 3

| width of light-screening pattern W(μm) | width of light-transmitting area W₁(μm) |
|---|---|
| 2.5 | 1.0 |
| 2.5 | 1.5 |
| 2.5 | 2.0 |
| 3.0 | -1.0 |
| 3.0 | 1.5 |
| 3.0 | 2.0 |
| 3.5 | 1.0 |
| 3.5 | 1.5 |
| 3.5 | 2.0 |
| 4.0 | 1.0 |
| 4.0 | 1.5 |
| 4.0 | 2.0 |

As already described, a phase-shifting layer is a thin film for shifting the optical phase of a light transmitted through a light-transmitting area relatively to the optical phase of a light transmitted through the area of a photomask other than the area of the light-transmitting area. The phase-shifting layer 130 is provided in such a way to perfectly cover the auxiliary aperture 128 but not extend beyond the light-screening pattern 124. Like in the Examples already described, a phase-shifting layer is suitably formed of a material transparent to an exposure light and easy of film thickness control, preferred examples of which include an $SiO_2$ film, an SiN film, an $MgF_2$ film, and resist films such as a PMMA film. The phase-shifting layer 130 in this case is formed of a thin film of a negative resist called "OEBR-100" (trade name of a product manufactured by Tokyo Ohka Kogyo Co., Ltd.). The thickness d of the phase-shifting layer 130 was determined according to the aforementioned equation (1) just like in the Examples already described to be about 3,000 Å. In this case, $\lambda$, which is the wavelength of an exposure light, is 365 nm (for i-line), while n standing for the refractive index at $\lambda$ of OEBR-100 is about 1.65. In this case as well, k may be any arbitrary value falling within the range of 1/4 to 3/4, but may usually be set to be 1/2, while $\ell$ may be 0 or a positive integer, but is preferably 0 in this case.

Although the light transmitted through the phase-shifting layer 130 is shifted in optical phase as compared with a transmitted light in the absence of the phase-shifting layer 130, the degree of shift of the optical phase of that light is preferably such as to provide a light intensity of zero on the surface of a wafer as a result of light interference, namely 180°.

Next, a brief description will be made of the procedure of forming the photomask in this case of Example 3 to facilitate the understanding of the structure of the above-mentioned photomask. However, the following procedure is a mere exemplification, and hence obviously should not be construed as limiting the scope of the present invention.

In this case of Example 3, preparation is first made of a quartz substrate of 0.09 inch (one inch corresponds to about 2.54 cm, the same will apply hereinafter) in thickness having a chrome film formed on one surface thereof and adapted for production of a photomask capable of light exposure therethrough to a silicon wafer of 5 inches in diameter (hereinafter referred to in brief as a "quartz substrate"). A resist for electron beam writing is applied on the chrome film of the quartz substrate.

Subsequently, electron beam writing is carried out on the resulting resist film with an electron beam exposure tool Model MEBES III (manufactured by Perkin-Elmer) on the basis of data produced according to .CAD. In this step, an alignment mark instrumental in formation of a phase-shifting layer is also written on the substrate. Thereafter, the exposed resist film is developed to form a resist pattern.

Subsequently, the exposed portions of the chrome film extending outside the areas of the resist pattern are removed to form a light-screening (or opaque) pattern 124 having an auxiliary aperture 128 formed therein. Incidentally, feature sizes of, for example, 2 μm and 3 μm on the basis of CAD were translated into 1.96 μm and 2.95 μm, respectively, in the light-screening pattern 124 formed according to the foregoing procedure.

Subsequently, a resist OEBR-100 for electron beam writing is applied on the surface of the substrate 122 having the light-screening pattern 124 formed thereon to form a resist film having a thickness of 5,500

13

Å.

Subsequently, electron beam writing is carried out on the resist film with the same electron beam exposure tool as used before on the basis of data produced according to CAD in preparations for formation of the phase-shifting layer 130. Incidentally, such writing was done with an accuracy of at most 0.1 $\mu$m in terms of registration with the alignment mark formed before, while the conditions of electron beam exposure involved an acceleration voltage of 10 KeV and an amount of exposure of 0.8 $\mu$C/cm$^2$.

Subsequently, the exposed resist film is developed with a special developing solution OEBR-100DE (trade name of a product manufactured By Tokyo Ohka Kogyo Co., Ltd.) for 3 minutes and rinsed with a special rinse for OEBR-100 (manufactured by Tokyo Ohka Kogyo Co., Ltd.) for 1 minute. Thereafter, the rinsed photomask is baked in a baking furnace at a temperature of 130 °C for 30 minutes. Incidentally, the thickness of the OEBR-100 film remaining after the baking was about 3,000 Å. In the foregoing manner, the photomask 120 according to this Example was produced.

(ii) Hole Patterns

A description will be made of a photomask for use in formation of a hole pattern as an isolated pattern. In this case as well, the photomask 140 according to this Example is actually provided with a number of mask patterns differing in features sizes for the experimental purpose as will be described later. Figs. 15(a) and 15(b) are a plan view and a cross-sectional view, respectively, of part of the photomask 140 including one mask pattern among a plurality of mask patterns formed on a quartz substrate 142.

The photomask 140 is produced in substantially the same manner as described above in connection with the production of the photomask for use in space pattern formation. In other words, the basic idea on the production of the photomask 140 is the same as that on the production of the photomask for space pattern formation. As is well known, however, a mask pattern on a photomask for use in formation of a hole pattern of m x c (wherein m is a reduction as mentioned hereinbefore) in diameter is in the form of a c x c square. In the photomask 140, therefore, a quadrate mask pattern 152 is provided on the same quartz substrate 122 as used in the production of the photomask for space pattern formation. The mask pattern 152 is provided with an isolated quadrate light-screening pattern 144 with a length c of sides, on the inside of which a light-transmitting area 146 is provided in the form of a square with a length d of sides. In the light-transmitting area 146, a phase-shifting layer 150 is provided in such a way as to fill up therewith an auxiliary aperture 148 provided in the light-screening pattern 152. The phase-shifting layer 150 is in the form of a thin quadrate film with a length of e of sides. In Fig. 15(a), the layer 150 is shown by marking it with dots and the pattern 152 by marking it with oblique lines.

The single photomask 140 is provided with various mask patterns for hole mask formation which differ in dimensions c, d and e as listed in Table 4.

Table 4

| c | d | e |
|---|---|---|
| ($\mu$m) | ($\mu$m) | ($\mu$m) |
| 3.0 | 1.0 | 2.0 |
| 3.0 | 1.5 | 2.0 |
| 3.5 | 1.0 | 2.0 |
| 3.5 | 1.5 | 2.0 |
| 3.5 | 2.0 | 3.0 |
| 4.0 | 1.0 | 2.0 |
| 4.0 | 1.5 | 3.0 |
| 4.0 | 2.0 | 3.0 |
| 5.0 | 1.0 | 2.0 |
| 5.0 | 1.5 | 2.0 |
| 5.0 | 2.0 | 3.0 |

Next, a description will be made of patterning experiments wherein space patterns and hole patterns were formed using these photomasks 120 and 140, respectively, as well as of the results of these

14

experiments.

The patterning experiments using the photomasks 120 and 140 for space pattern formation and hole pattern formation, respectively, were carried out under the following conditions. Incidentally, use was made of a projection aligner Model RA101VL II (manufactured by Hitachi, Ltd.) with a numerical aperture (NA) of 0.42 and a reduction of 1/10 wherein the i-line (wavelength: 365 nm) was used as an exposure light, while LMR-UV (a resist manufactured by Fuji Yakuhin Kogyo K.K.) was used as a negative resist.

First, the above-mentioned LMR-UV was applied on the surface of a silicon substrate 200 of 3 inches in diameter as the underlying layer by spin coating to form a resist film 210 having a thickness of 1 $\mu$m, which was then softly baked on a hot plate at a temperature of 70 °C for 1 minute (Fig. 16(a)).

Subsequently, the photomask 140 for hole pattern formation was set in the projection aligner Model RA101VL II, under which the baked silicon substrate 200 covered with the resist film 210 was placed. The photomask 140 is provided with a plurality of mask patterns, but in Fig. 16(b), one 154 of the mask patterns is shown for forming a hole pattern. Light exposure was effected to project the mask pattern 154 through the lense system 225 of the projection aligner to form isolated hole pattern 220 on the resist surface while independently varying the amount of light exposure and the focus.

Subsequently, the exposed silicon substrate was baked on a hot plate at a temperature of 110°C for 1 minute. Thereafter, the baked resist film was developed with a special developing solution for LMR-UV to form an isolated resist pattern 230.

The resist pattern were measured in size and observed with a scanning electron microscope Model S-6000 capable of dimensional measurement (manufactured by Hitachi, Ltd.).

The observation revealed the following results. When the amount of light exposure was 180 mJ/cm$^2$, a mask pattern with W = 2.5 $\mu$m and $W_1$ = 1 $\mu$m (in Table 3) on the photomask for space pattern formation was found to have been translated, or reproduced, into a space pattern of 0.25 $\mu$m in width and 1,200 $\mu$m in length in the resist pattern obtained through the projection exposure. This space pattern was found to have been resolved over a depth of focus of 1 $\mu$m. With the same amount of light exposure as mentioned above (180 mJ/cm$^2$), a 0.3 $\mu$m-wide space pattern was found to have been formed with a focus margin of 1.6 $\mu$m in the area of the resist pattern projection-exposed through a mask pattern with W = 3 $\mu$m and $W_1$ = 1 $\mu$m (in Table 3) on the photomask for space pattern formation. A 0.3 $\mu$m-wide space pattern was found to have been formed with a focus margin of 1.2 $\mu$m in the area of the resist pattern projection-exposed through a mask pattern with W = 3 $\mu$m and $W_1$ = 1.5 $\mu$m (in Table 3) on the photomask for space pattern formation. Substantially the same resolutions and focus margins as mentioned above can also be expected in the cases of W = 2.5 $\mu$m and $W_1$ = 1.5 $\mu$m; W = 2.5 $\mu$m and $W_1$ = 2.0 $\mu$m; and W = 3.0 $\mu$m and $W_1$ = 2.0 $\mu$m (in Table 3). In the case of W = 3.5 $\mu$m and $W_1$ = 4.0 $\mu$m, no noticeable effects could not be secured.

Substantially the same patterning experiment as described above was made using the photomask 140 having a number of mask patterns for hole pattern formation. As a result, it was found that, when the amount of light exposure was 140 mJ/cm$^2$, a mask pattern with c = 3 $\mu$m and d = 1.5 $\mu$m (in Table 4) for hole pattern formation was translated, or reproduced, into a space pattern of 0.3 $\mu$m in diameter (resolution) in the resist pattern obtained through projection exposure, while the focus margin was 1 $\mu$m. Substantially the same resolutions and focus margins as mentioned above can be expected in other cases in Table 4.

(iii) Comparative Photomasks

For comparison, substantially the same patterning experiments were made using photomasks of a conventional structure comprising light-screening patterns equal in size to those of the photomasks of Example 3 but each devoid of a light-transmitting area.

Through the comparative patterning experiment, an amount of light exposure and a focus capable of translating, or reproducing, a 2.5 $\mu$m-wide mask pattern on the photomasa for space pattern formation into a 0.25 $\mu$m-wide space pattern in a resist pattern was sought but could not be found. Even when the amount of light exposure was 160 mJ/cm$^2$ which had been believed to be suitable, no space pattern was secured at all in the resist pattern. When the amount of light exposure was 150 mJ/cm$^2$, a 0.3 $\mu$m-wide space pattern was formed in the resist pattern.

When the amount of the light exposure was 180 mJ/cm$^2$, a 3 $\mu$m-wide mask pattern on the photomask for space pattern formation was translated into a 0.3 $\mu$m-wide space pattern in the resist pattern, but the focus margin was 0.6 $\mu$m, which was found to be less than 1/2 of those in Example 3.

On the other hand, through the comparative patterning experiment using the photomask comprising light-screening patterns each devoid of a light-transmitting area as mask patterns for hole pattern formation, it was found that a mask pattern 3 μm square on the photomask could not be translated, or reproduced, into any hole pattern at all in a resist film (could not be resolved at all).

While the Examples according to the present invention have been described, the present invention is not limited to the foregoing Examples, but obviously is capable of various alternations and modifications.

For example, the light-screening layers and phase-shifting layers constituting the mask patterns can obviously be altered into arbitrary and suitable shapes in accordance with designing of semiconductor devices and the like. The tool, the chemicals, etc. used in the Examples have be mere exemplifications, and hence can obviously by replaced with other suitable ones.

As is apparent from the foregoing description, the photomask of the present invention for negative resist which is used to form an isolated pattern can be not only quite simple in the structure of a mask pattern itself but also excellent in resolution in addition to an improvement in focus margin in the case where the mask pattern is formed of a phase-shifting layer alone without using any opaque layer.

Not only where the mask pattern is constituted of an opaque layer and a phase-shifting layer provided at least substantially around the opaque layer but also where the mask pattern is constituted of an opaque layer provided with an auxiliary aperture and a phase-shifting layer provided in the auxiliary aperture, the photomask of the present invention is excellent in resolution and allows for a greater focus margin as well.

Accordingly, the use of the photomask of the present invention for a negative resist enables either a space pattern so fine as never realizable by the prior art technologies to be formed with an improved focus margin. This allows for a countermeasure to cope with the focus margins of projection aligner ever-decreasing in step with an increase in area subjected to light exposure, etc.

Furthermore, according to the process of the present invention for forming a resist image as an isolated pattern, resist patterns so fine as to exceed the resolution limit if in a sense of the prior art can be formed in substantially the same manner as in the prior art technologies to facilitate the production of LSI semiconductor devices.

## Claims

1. A photomask (40; 60; 70) adapted to be used in a projection aligner to project the mask pattern thereof in the form of an isolated pattern on the surface of a wafer having a negative resist film formed thereon, comprising:
a substrate (42) transparent to an exposure light, and
a mask pattern (44; 62; 64) provided on said substrate;
wherein said mask pattern is formed of a phase-shifting layer (44; 62; 64) capable of transmitting said exposure light therethrough and shifting the phase of said exposure light transmitted therethrough relatively to the phase of said exposure light transmitted through the area of the photomask other than the area of said phase-shifting layer.

2. A photomask (40; 60) as claimed in claim 1, wherein said mask pattern (44; 62) formed of said phase-shifting layer (44; 62) is in a striped form to thereby enable the mask pattern to be projected as said isolated pattern on the surface of said wafer to form a space pattern in the form of said isolated pattern in said negative resist.

3. A photomask (40; 70) as claimed in claim 1, wherein said mask pattern (44; 64) formed of said phase-shifting layer (44; 64) is in a quadrate form to thereby enable said mask pattern to be projected as the isolated pattern on the surface of said wafer to form a hole pattern in the form of said isolated pattern in the negative resist.

4. A photomask as claimed in claim 1, wherein the width W of said mask pattern formed of said phase-shifting layer is such as to be expressed by the following equation:
$$W = P\frac{\lambda}{NA}$$
wherein $0 < P \leq 0.6$, $\lambda$ stands for the wavelength of said exposure light, and NA stands for the numerical aperture of the projection aligner.

5. A photomask as claimed in claim 1, wherein the thickness d of said mask pattern formed of said phase-shifting layer is such as to be expressed by the following equation:
$$d = (\ell + k)\lambda/(n - 1)$$
wherein $1/4 \leq k \leq 3/4$, $\lambda$ stands for the wavelength of said exposure light, n stands for the refractive index at $\lambda$ of said phase-shifting layer, and $\ell$ is 0 or a positive integer.

6. A photomask (80; 90) adapted to be used in a projection aligner to project the mask pattern thereof in the form of an isolated pattern on the surface of a wafer having a negative resist film formed thereon, comprising:

a substrate (82; 92) transparent to an exposure light, and

a mask pattern (84 and 86; 94 and 96) provided on said substrate;

wherein said mask pattern is constituted of a light-screening layer (84; 94) and a phase-shifting layer (86; 96), said light-screening layer being incapable of transmitting said exposure light therethrough and having a width permitting of no resolution by itself, and said phase-shifting layer being capable of transmitting the exposure light therethrough and shifting the phase of the exposure light transmitted therethrough relatively to the phase of the exposure light transmitted through the area of the photomask other than the area of said phase-shifting layer; and

wherein said phase-shifting layer with one and the same width is provided in contact with said light-screening layer in such a way as to at least substantially surround said light-screening layer.

7. A photomask (80) as claimed in claim 6, wherein said light-screening layer (84) is in a striped form and said phase-shifting layer (86) is constituted of first and second striped phase-shifting layer areas (86, 86) separately disposed on the respective sides of said light-screening layer (84), whereby said mask pattern (84 and 86) can be projected as said isolated pattern on the surface of said wafer to form a space pattern in the form of said isolated pattern in the negative resist film.

8. A photomask (90) as claimed in claim 6, wherein said light-screening layer (94) is in a quadrate form and said phase-shifting layer (96) is disposed all around said light-screening layer, whereby the mask pattern (94 and 96) can be projected as said isolated pattern on the surface of said wafer to form a hole pattern in the form of said isolated pattern in said negative resist film.

9. A photomask as claimed in claim 6, wherein the thickness d of said phase-shifting layer is such as to be expressed by the following equation:

d = (ℓ + k)λ/(n - 1)

wherein 1/4 ≤ k ≤ 3/4, λ stands for the wavelength of said exposure light, n stands for the refractive index at λ of said phase-shifting layer, and ℓ is 0 or a positive integer.

10. A photomask (100; 120; 140) adapted to be used in a projection aligner to project the mask pattern thereof in the form of an isolated pattern on the surface of a wafer having a negative resist film formed thereon, comprising:

a substrate (102; 122; 142) transparent to an exposure light, and

a mask pattern (110; 132; 154) provided on said substrate;

wherein said mask pattern is formed of a light-screening layer (112; 124; 152) and a phase-shifting layer (116; 130; 150), said light-screening layer being incapable of transmitting said exposure light therethrough, and said phase-shifting layer being capable of transmitting said exposure light therethrough and shifting the phase of said exposure light transmitted therethrough relatively to the phase of said exposure light transmitted through the area of the photomask other than the area of said phase-shifting layer;

wherein said phase-shifting layer is provided in such a way as to fill up therewith an auxiliary aperture (114; 128; 148) provided in said light-screening layer;

wherein the portion of said phase-shifting layer with which said auxiliary aperture is filled up has a width permitting of no resolution by itself; and

wherein the areas of said light-screening layer respectively existing around sides of said phase-shifting layer and in the width-wise direction of said phase-shifting layer have one and the same width.

11. A photomask (120) as claimed in claim 10, wherein said areas of said light-screening layer (112; 124) and said phase-shifting layer (116; 130) are in a striped form to thereby enable said mask pattern (110; 132) to be projected as said isolated pattern on the surface of said wafer to form a space pattern in the form of said isolated pattern in said negative resist film.

12. A photomask (110; 154) as claimed in claim 10, wherein said light-screening layer (112; 152) and said phase-shifting layer (116; 150) are in a quadrate form to thereby enable said mask pattern (110; 154) to be projected as said isolated pattern on the surface of said wafer to form a hole pattern in the form of said isolated pattern in said negative resist film.

13. A photomask as claimed in claim 10, wherein the thickness d of the phase-shifting layer is such as to be expressed by the following equation:

d = (ℓ + k) λ/(n - 1)

wherein 1/4 ≤ k ≤ 3/4, λ stands for the wavelength of said exposure light, n stands for the refractive index at λ of the phase-shifting layer, and ℓ is 0 or a positive integer.

14. A photomask as claimed in claim 1, wherein the amount of phase shift by said phase-shifting layer is preferably 180°.

15. A photomask as claimed in claim 6, wherein the amount of phase shift by said phase-shifting layer is preferably 180°.

16. A photomask as claimed in claim 10, wherein the amount of phase shift by said phase-shifting layer is preferably 180°.

17. A process for forming resist image in the form of an isolated pattern using the photomask (40; 60; 70) of claim 1, comprising the step of applying a negative resist (210) on an underlying layer (200), the step of exposing the resulting negative resist film through said photomask for use in isolated pattern projection to a light, and the step of developing the light-exposed negative resist film (210).

18. A process for forming resist image in the form of an isolated pattern using the photomask (80; 90) of claim 6, comprising the step of applying a negative resist (210) on an underlying layer (200), the step of exposing the resulting negative resist film through said photomask for use in isolated pattern projection to a light, and the step of developing the light-exposed negative resist film (210).

19. A process for forming resist image in the form of an isolated pattern using the photomask (100; 120; 140) of claim 10, comprising the step of applying a negative resist (210) on an underlying layer (200), the step of exposing the resulting negative resist film through said photomask for use in isolated pattern projection to a light, and the step of developing the light-exposed negative resist film (210).

## FIG.1

EP 0 401 795 A2

*FIG_2*(a)

*FIG_2*(b)

*FIG_3*(a)

W

40

42

44

*FIG_3*(b)

ELECTRIC FIELD AT WAFER

0    POSITION

*FIG_3*(c)

LIGHT INTENSITY AT WAFER

0    POSITION

## FIG. 4 (a)

## FIG. 4 (b)

## FIG. 4 (c)

FIG_5 (a)

FIG_5 (b)

FIG_5 (c)

*FIG. 6* (a)

60

42

62

*FIG. 6* (b)

60

42

I      I

62

W

_FIG. 7_ (a)

_70_

42

64

_FIG. 7_ (b)

_70_

42

I

I

64

W

*FIG_8* ( a )

*FIG_8* ( b )

*FIG_8* ( c )

FIG. 9 (a)

FIG. 9 (b)

FIG. 9 (c)

*FIG. 10* (a)

82, 92

84, 94

86, 96

*FIG. 10* (b)

ELECTRIC FIELD AT WAFER

0     POSITION

*FIG. 10* (c)

LIGHT INTENSITY AT WAFER

0     POSITION

*FIG. 11* (a)

*FIG. 11* (b)

*FIG. 11* (c)

## FIG_12 (a)

## FIG_12 (b)

## FIG_12 (c)

*FIG.13* (a)

65

42

63          67          63

*FIG.13* (b)

ELECTRIC FIELD AT WAFER

0          POSITION

*FIG.13* (c)

LIGHT INTENSITY AT WAFER

0          POSITION

*FIG.14* (a)

*FIG.14* (b)

# FIG. 15 (a)

# FIG. 15 (b)

*FIG. 16* (a)

210
200

154
150  152

140

*FIG. 16* (b)

142

225

220

210
200

*FIG. 16* (c)

230

210

200